# EUROPEAN PATENT APPLICATION

(11) **EP 4 116 746 A1**
(43) Date of publication of application: **11.01.2023**
(21) Application number: 20842664.3
(22) Date of filing: 25.03.2020
(51) Int. Cl.: G02B 5/30, G02B 5/18, G02B 1/14, H01L 51/52

(54) **POLARIZER SHEET AND DISPLAY PANEL**

(30) Priority: 05.03.2020 CN 202010147623
(71) Applicant: Wuhan China Star Optoelectronics Semiconductor Display Technology Co., Ltd., Wuhan, Hubei 430079 (CN)
(72) Inventor: CHEN, Hui, Wuhan Hubei 430079 (CN)
(74) Representative: Ström & Gulliksson AB
(86) International application number: PCT/CN2020/081060
(87) International publication number: WO 2021/174609

(57) **Abstract**

The present application provides a polarizer and a display panel. The polarizer includes a linearly polarizing layer and a circularly polarizing layer arranged opposite to each other. A grating structure is arranged at one side of the linearly polarizing layer adjacent to or/and away from the circularly polarizing layer.

## Description

### BACKGROUND

### Technical Field

The present application relates to a field of display technology and in particular, to a polarizer and a display panel.

### Related Art

Color-shifting problems at large viewing angles in OLED devices mainly result from the full width at half maxima (FWHM) of light rays in top-emitting OLED devices being narrowed by filtering effects for optical waves in the microchamber structure. Since red, green and blue light have different chromaticity reduction rates, the light intensity of each color light decreases differently, which results in the color-shifting problems.

### SUMMARY

The present application provides a polarizer to solve color-shifting problems of conventional display panels. In conventional display panels, chromaticity reduction rates of red, green, and blue light rays are different at large viewing angles, so light intensity of each color light is decreased differently, which results in the color-shifting problems.

In one aspect, the present application provides a polarizer. The polarizer comprises a linearly polarizing layer and a circularly polarizing layer disposed opposite to each other, wherein a grating structure is disposed at one side of the linearly polarizing layer adjacent to or/and away from the circularly polarizing layer.

In some embodiments, a grating constant of the grating structure ranges from 0.08 micrometers to 1.2 micrometers.

In some embodiments, the polarizer further comprises an upper protective layer disposed on one side of the linearly polarizing layer away from the circularly polarizing layer, and a lower protective layer disposed between the linearly polarizing layer and the circularly polarizing layer.

In some embodiments, the grating structure is disposed on the upper protective layer or/and the lower protective layer.

In some embodiments, the grating structure is disposed on one side of the upper protective layer away from the linearly polarizing layer, or/and the grating structure is disposed on one side of the lower protective layer away from the linearly polarizing layer.

In some embodiments, the grating structure is disposed on one side of the upper protective layer adjacent to the linearly polarizing layer, or/and the grating structure is disposed on one side of the lower protective layer adjacent to the linearly polarizing layer.

In some embodiments, when the grating structure is disposed on the upper protective layer, the grating structure is integrally formed with the upper protective layer; and when the grating structure is disposed on the lower protective layer, the grating structure is integrally formed with the lower protective layer.

In some embodiments, material of the upper protective layer, the lower protective layer, and the grating structure comprises an optical resin material.

In some embodiments, the polarizer further comprises an adhesive layer disposed on one side of the circularly polarizing layer away from the linearly polarizing layer.

In another aspect, the present application provides a display panel. The display panel comprises a display body and a polarizer, wherein the polarizer is disposed on a light-emitting side of the display body, the polarizer comprises a linearly polarized layer and a circularly polarized layer disposed opposite to each other, and a grating structure is disposed at one side of the linearly polarizing layer adjacent to or/and away from the circularly polarizing layer.

In some embodiments, a grating constant of the grating structure ranges from 0.08 micrometers to 1.2 micrometers.

In some embodiments, the polarizer further comprises an upper protective layer disposed on one side of the linearly polarizing layer away from the circularly polarizing layer, and a lower protective layer disposed between the linearly polarizing layer and the circularly polarizing layer.

In some embodiments, the grating structure is disposed on the upper protective layer or/and the lower protective layer.

In some embodiments, the grating structure is disposed on one side of the upper protective layer away from the linearly polarizing layer, or/and the grating structure is disposed on one side of the lower protective layer away from the linearly polarizing layer.

In some embodiments, the grating structure is disposed on one side of the upper protective layer adjacent to the linearly polarizing layer, or/and the grating structure is disposed on one side of the lower protective layer adjacent to the linearly polarizing layer.

In some embodiments, when the grating structure is disposed on the upper protective layer, the grating structure is integrally formed with the upper protective layer; and when the grating structure is disposed on the lower protective layer, the grating structure is integrally formed with the lower protective layer.

In some embodiments, material of the upper protective layer, the lower protective layer, and the grating structure is made of an optical resin material.

In some embodiments, the polarizer further comprises an adhesive layer disposed on one side of the circularly polarizing layer away from the linearly polarizing layer.

Advantages of the present application:
The grating structure is arranged on the upper protective layer or/and the lower protective layer without damaging the overall structure of the linearly polarizing layer and the circularly polarizing layer, and at the same time, when light emitted from the display body passes through the grating structure, light diffraction occurs. Due to the light diffraction effect, the light is distributed to regions at larger viewing angles, thus compensating for light intensity at regions at large viewing angles. Such configurations reduce color shifts resulting from differently decreased light intensity of each color light without reducing the overall brightness of the display panel, and the display quality also improves.

### BRIEF DESCRIPTION OF THE DRAWINGS

In order to more clearly illustrate the embodiments of the present disclosure or related art, figures which will be described in the embodiments are briefly introduced hereinafter. It is obvious that the figures are merely for the purposes of illustrating some embodiments of the present disclosure, and a person having ordinary skill in this field can obtain other figures according to these figures without inventive work.
FIG. 1 is a schematic structural view illustrating a polarizer according to a first embodiment of the present invention.
FIG. 2 is a graph illustrating light intensity distribution for red light rays, green light rays, and blue light rays at different viewing angles after compensation for light intensity.
FIG. 3 and FIG. 4 are schematic structural views illustrating the polarizer according to a second embodiment of the present invention.
FIG. 5 is a schematic structural view illustrating a display panel according to one embodiment of the present invention.

### DETAILED DESCRIPTION

In order to make the purposes, technical solutions, and effects of the present application clear, the present application is described in detail below with reference to the accompanying drawings and in conjunction with specific embodiments. Please be noted that the specific embodiments described herein are only used to explain the present application, and are not intended as limitations to the present application.

The present invention is directed to solving a problem of conventional display panels. The problem is that, red light, green light, and blue light have different chromaticity reduction rates at large viewing angles, thus resulting in different degrees of light intensity reduction of each color light, which leads to color shifts. The present invention can solve the above problem.

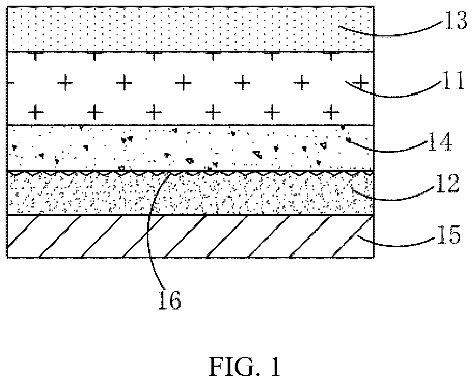

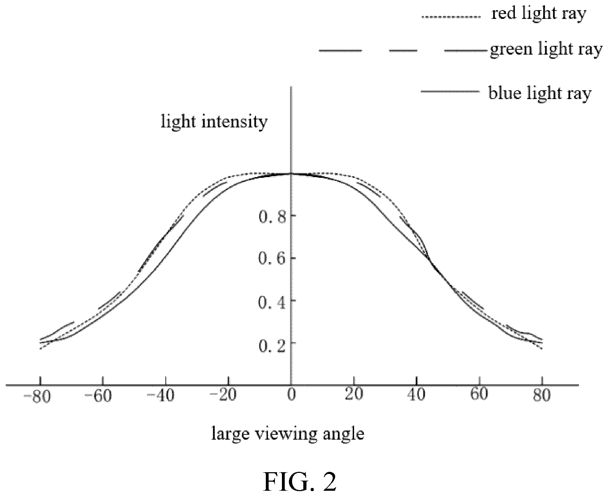

Please refer to FIGs. 1 and 2 illustrating a polarizer 10 of the present invention. The polarizer 10 comprises a linearly polarizing layer 11 and a circularly polarizing layer 12 disposed opposite to each other, wherein a grating structure 16 is disposed at one side of the linearly polarizing layer 11 adjacent to or/and away from the circularly polarizing layer 12.

The linearly polarizing layer 11 can be made of polyvinyl alcohol, the circularly polarizing layer 12 is used to convert linear polarization to circular polarization, and the grating structure 16 can be a phase grating.

It is apparent to those skilled in the art that, light is diffracted after passing through a wavelength level microstructure. According to the principle of energy conservation, it can be understood that the original concentrated light intensity is distributed to a region at larger viewing angles due to light diffraction. Therefore, the light intensity in other regions is supplemented. Similarly, after the polarizer 10 is attached to a light-emitting side of a display body 20, the light passing through the grating structure 16 is distributed to larger viewing angles due to light diffraction, thus compensating for the light intensity in the region at larger viewing angles. Color shifts caused by decrease in the light intensity of each color light are reduced without lowering the overall brightness of the display panel, thus improving display quality.

Specifically, a grating constant of the grating structure 16 is 0.08 micrometers to 1.2 micrometers, and the grating constant of the grating structure 16 can be 0.1 micrometer, 0.2 micrometer, 0.5 micrometer, 0.8 micrometer, or 1 micrometer.

It should be noted that, when light emitted from the display body 20 passes through the polarizer 10, blue light rays have a greatest attenuation rate and a largest amount of attenuation of light compared to red light rays and green light rays. The grating constant of the grating structure 16 is designed to make the grating constant close to the width of the short wavelength of the blue light rays, so diffraction effects for the blue light rays are stronger. The diffraction effects can slow down the attenuation of light intensity of the blue light rays at large viewing angles, thereby further reducing color shifts.

It should be noted that, FIG. 2 is a graph illustrating light intensity distribution for red light rays, green light rays, and blue light rays at different viewing angles after light intensity compensation. The abscissa indicates large viewing angles, the ordinate indicates the light intensity, the dotted line indicates the light intensity distribution of the red light rays, the dashed line indicates the light intensity distribution of the green light rays, and the solid line indicates the light intensity distribution of the blue light rays. It can be seen from FIG. 2 that, the light intensity of the blue light rays slowly decreases after the light intensity compensation, and the light intensities of the blue light rays and the red light rays and the green light rays are reduced by a similar extent at larger viewing angles.

In detail, the polarizer 10 further comprises an upper protective layer 13 disposed on one side of the linearly polarizing layer 11 away from the circularly polarizing layer 12, and a lower protective layer 14 disposed between the linearly polarizing layer 11 and the circularly polarizing layer 12.

To be specific, the grating structure 16 is disposed on the upper protective layer 13 or/and the lower protective layer 14.

The upper protective layer 13, the lower protective layer 14, and the grating structure 16 are made of an optical resin material. The optical resin material comprises, but is not limited to, polymer resin materials such as cellulose triacetate (TAC), acrylic (PMMA), and cyclo-olefin polymer (COP). Both the upper protective layer 13 and the lower protective layer 14 made of the optical resin material can serve as a protective layer to protect the linearly polarizing layer 11 and also serve as a base for the grating structure 16.

It should be noted that, the grating structure 16 can cover the entire surface of the upper protective layer 13 or/and the lower protective layer 14, so all color lights can be diffracted to compensate for the light intensity in all regions at large viewing angles. At the same time, by adjusting the grating constant of the grating structure 16, the diffraction effect for the blue light rays is the strongest, so the color shift is reduced. The grating structure 16 can also be disposed only at a predetermined area in the polarizer 10, and the predetermined area is an area in the polarizer 10 corresponding to blue sub-pixels of the display body 20 when the polarizer 10 is attached to the display body 20.

According to a first embodiment of the present application, the grating structure 16 is disposed at one side of the upper protective layer 13 away from the linearly polarizing layer 11, or /and the grating structure 16 is disposed at one side of the lower protective layer 14 away from the linearly polarizing layer 11.

That is, when the grating structure 16 is disposed on the upper protective layer 13, the grating structure 16 is disposed on one side of the upper protective layer 13 away from the linearly polarizing layer 11; and when the grating structure 16 is disposed on the lower protective layer 14, the grating structure 16 is disposed on one side of the lower protective layer 14 away from the linearly polarizing layer 11.

It should be noted that, in a process of producing the polarizer 10, the lower protective layer 14, the linearly polarizing layer 11, and the upper protective layer 13 which are sequentially stacked are formed first, and then, the grating structure 16 is formed on an outer surface of the upper protective layer 13 or/and an outer surface of the lower protective layer 14 by using technologies such as nano-imprinting. After that, the circularly polarizing layer 12 made by a stretching process is attached to the outer surface of the lower protective layer 14, or the circularly polarizing layer 12 is directly formed on the outer surface of the lower protective layer 14 by coating.

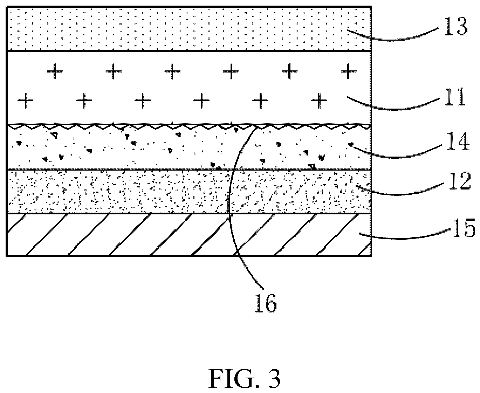

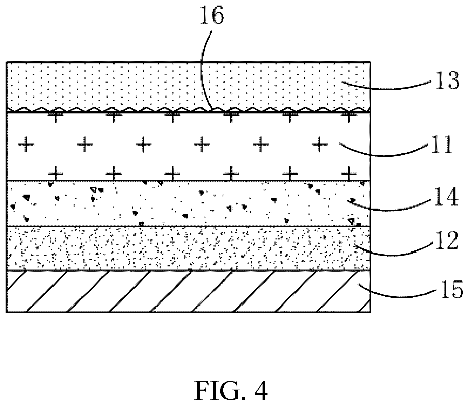

According to a second embodiment of the present application, as shown in FIGs. 3 and 4, the grating structure 16 is disposed on one side of the upper protective layer 13 adjacent to the linearly polarizing layer 11, or/and the grating structure 16 is disposed on one side of the lower protective layer 14 adjacent to the linearly polarizing layer 11.

That is, when the grating structure 16 is disposed on the upper protective layer 13, the grating structure 16 is disposed on one side of the upper protective layer 13 adjacent to the linearly polarizing layer 11; and when the grating structure 16 is disposed on the lower protective layer 14, the grating structure 16 is disposed on one side of the lower protective layer 14 adjacent to the linearly polarizing layer 11.

It should be noted that, in the process of producing the polarizer 10, a technology such as nano-imprinting can be used to form the grating structure 16 on a surface of the upper protective layer 13 or/and a surface of the lower protective layer 14. Then, one side of the upper protective layer 13 or/and one side of the lower protective layer 14 provided with the grating structure 16 is attached to the linearly polarizing layer 11, and the circularly polarizing layer 12 made by the stretching process is attached to the outer surface of the lower protective layer 14, or the circularly polarizing layer is directly formed on the outer surface of the lower protective layer 14 by coating.

It should be noted that FIG. 3 and FIG. 4 only show the case where the grating structure 16 is provided only on the upper protective layer 13 or the lower protective layer 14. However, in practice, both the upper protective layer 13 and the lower protective layer 14 can be provided with the grating structure 16.

Specifically, when the grating structure 16 is disposed on the upper protective layer 13, the grating structure 16 is integrally formed with the upper protective layer 13; when the grating structure 16 is disposed on the lower protective layer 14, the grating structure 16 is integrally formed with the lower protective layer 14.

Specifically, the grating structure 16 can be a plurality of transparent prisms spaced apart from each other, and the grating structure 16 can also be formed by hollowing out portions in an entire surface structure.

Specifically, the polarizer 10 further comprises an adhesive layer 15 disposed on one side of the circularly polarizing layer 12 away from the linearly polarizing layer 11. The adhesive layer 15 is used to attach the polarizer 10 to the display body 20. The adhesive layer 15 can be made of polysulfone amide.

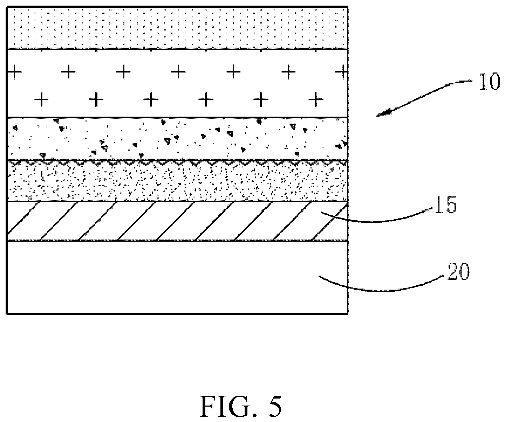

Based on the polarizer 10 mentioned above, the present invention also provides a display panel. As shown in FIG. 5, the display panel comprises a display body 20 and the polarizer 10 of any one of the above embodiments. The polarizer 10 is disposed on a light emitting side of the display body 20, the polarizer 10 is attached to the light emitting side of the display body 20 through the adhesive layer 15.

Advantages of the present application:
The grating structure 16 is arranged on the upper protective layer or/and the lower protective layer 14 without damaging the overall structure of the linearly polarizing layer 11 and the circularly polarizing layer 12, and at the same time, when the light emitted from the display body 20 passes through the grating structure 16, light diffraction occurs. Due to the light diffraction effect, the light is distributed to regions at larger viewing angles, thus compensating for the light intensity at regions at large viewing angles. Such a configuration reduces color shifts resulting from differently decreased light intensity of each color light without reducing the overall brightness of the display panel, and the display quality also improves.

In the above embodiments, the description of each embodiment has its own emphasis. For those which are not described in detail in one embodiment, please refer to related descriptions in other embodiments.

Specific examples are used herein to explain the working principles and embodiments of the present application. The descriptions of the above embodiments are only used for ease of understanding the technical solution and main ideas of the present application. Those skilled in the art can make modifications to the technical solutions described in the foregoing embodiments, or use equivalent replacements for some of the technical features. Such modifications or replacements are deemed to be within the protection scope of the present application.

## Claims

1. A polarizer, comprising:
a linearly polarizing layer and a circularly polarizing layer disposed opposite to each other, wherein a grating structure is disposed at one side of the linearly polarizing layer adjacent to or/and away from the circularly polarizing layer.

2. The polarizer according to claim 1, wherein a grating constant of the grating structure ranges from 0.08 micrometers to 1.2 micrometers.

3. The polarizer according to claim 1, further comprising an upper protective layer disposed on one side of the linearly polarizing layer away from the circularly polarizing layer, and a lower protective layer disposed between the linearly polarizing layer and the circularly polarizing layer.

4. The polarizer according to claim 3, wherein the grating structure is disposed on the upper protective layer or/and the lower protective layer.

5. The polarizer according to claim 4, wherein the grating structure is disposed on one side of the upper protective layer away from the linearly polarizing layer, or/and the grating structure is disposed on one side of the lower protective layer away from the linearly polarizing layer.

6. The polarizer according to claim 4, wherein the grating structure is disposed on one side of the upper protective layer adjacent to the linearly polarizing layer, or/and the grating structure is disposed on one side of the lower protective layer adjacent to the linearly polarizing layer.

7. The polarizer according to claim 4, wherein when the grating structure is disposed on the upper protective layer, the grating structure is integrally formed with the upper protective layer; and when the grating structure is disposed on the lower protective layer, the grating structure is integrally formed with the lower protective layer.

8. The polarizer according to claim 3, wherein material of the upper protective layer, the lower protective layer, and the grating structure comprises an optical resin material.

9. The polarizer according to claim 3, further comprising an adhesive layer disposed on one side of the circularly polarizing layer away from the linearly polarizing layer.

10. A display panel, comprising:
a display body and a polarizer;
wherein the polarizer is disposed on a light-emitting side of the display body, the polarizer comprises a linearly polarized layer and a circularly polarized layer disposed opposite to each other, and a grating structure is disposed at one side of the linearly polarizing layer adjacent to or/and away from the circularly polarizing layer.

11. The display panel according to claim 10, wherein a grating constant of the grating structure ranges from 0.08 micrometers to 1.2 micrometers.

12. The display panel according to claim 10, wherein the polarizer further comprises an upper protective layer disposed on one side of the linearly polarizing layer away from the circularly polarizing layer, and a lower protective layer disposed between the linearly polarizing layer and the circularly polarizing layer.

13. The display panel according to claim 12, wherein the grating structure is disposed on the upper protective layer or/and the lower protective layer.

14. The display panel according to claim 13, wherein the grating structure is disposed on one side of the upper protective layer away from the linearly polarizing layer, or/and the grating structure is disposed on one side of the lower protective layer away from the linearly polarizing layer.

15. The display panel according to claim 13, wherein the grating structure is disposed on one side of the upper protective layer adjacent to the linearly polarizing layer, or/and the grating structure is disposed on one side of the lower protective layer adjacent to the linearly polarizing layer.

16. The display panel according to claim 13, wherein when the grating structure is disposed on the upper protective layer, the grating structure is integrally formed with the upper protective layer; and when the grating structure is disposed on the lower protective layer, the grating structure is integrally formed with the lower protective layer.

17. The display panel according to claim 12, wherein material of the upper protective layer, the lower protective layer, and the grating structure is made of an optical resin material.

18. The display panel according to claim 12, wherein the polarizer further comprises an adhesive layer disposed on one side of the circularly polarizing layer away from the linearly polarizing layer.
